# EUROPÄISCHE PATENTSCHRIFT

(11) **EP 4 186 106 B1**
(45) Veröffentlichungstag und Bekanntmachung des Hinweises auf die Patenterteilung: **20.03.2024**
(21) Anmeldenummer: 21844277.0
(22) Anmeldetag: 21.12.2021
(51) Int. Cl.: H01L 31/042, H01L 31/18

(54) **VERFAHREN UND VORRICHTUNG ZUM HERSTELLEN VON SOLARMODULEN**
METHOD AND DEVICE FOR PRODUCING SOLAR PANELS
PROCÉDÉ ET DISPOSITIF POUR LA FABRICATION DE PANNEAUX SOLAIRES

(30) Priorität: 11.03.2021 DE 102021105986
(43) Veröffentlichungstag der Anmeldung: 31.05.2023
(73) Patentinhaber: M10 Solar Equipment GmbH, 79111 Freiburg (DE)
(72) Erfinder: ZAHN, Philipp Donatus Martin, 79117 Freiburg (DE); SCHNEIDEREIT, Günter, 79112 Freiburg (DE); JEHL, Dominique, 67860 Rhinau (FR)
(74) Vertreter: Mertzlufft-Paufler, Cornelius
(86) Internationale Anmeldenummer: PCT/EP2021/087147
(87) Internationale Veröffentlichungsnummer: WO 2022/189030

(56) Entgegenhaltungen:
- WO-A1-2016/063244
- WO-A2-2010/000812
- CN-A- 104 600 141
- DE-A1-102008 046 327
- DE-U1- 20 220 444
- US-A1- 2019 058 436

## Beschreibung

Die Erfindung betrifft ein Verfahren und eine Vorrichtung zum Herstellen von Solarmodulen.

Derartige Verfahren und Vorrichtungen sind aus der Praxis vorbekannt. Hierbei werden Photovoltaikzellen zu Zeilen zusammengesetzt und die Solarmodule aus elektrisch miteinander verbundenen Zeilen aufgebaut.

Die WO 2010/000812 A2 offenbart ein Verfahren zur Herstellung eines Solarmoduls umfassend in zumindest zwei parallel zueinander und auf einer Unterlage angeordneten Reihen von untereinander verschalteten Solarzellen gekennzeichnet durch die Verfahrensschritte in der Reihenfolge: Bereitstellen und Ausrichten der Unterlage, Ausrichten der Solarzellen und Positionieren dieser auf der Unterlage, Auflegen von Zellenverbindern auf einander zugewandten Randbereichen von aneinander grenzenden Solarzellen und Verbinden der Zellenverbinder mit den Randbereichen, Verbinden der untereinander verbundenen Solarzellen mit Querverbindern und Abdecken der verschalteten Solarzellen mit einer Abdeckung.

Die DE 202 20 444 U1 offenbart Photovoltaik-Module mit folgendem Aufbau: A) mindestens einer vorderseitigen, der Energiequelle zugewandten, äußeren Abdeckschicht aus Glas oder einem schlagzähen, UV-stabilen, witterungsstabilen, transparenten Kunststoff mit geringer Wasserdampfdurchlässigkeit, B) mindestens einer zwischen A) und C) befindlichen Kunststoffklebeschicht, in die mindestens eine oder mehrere Solarzellen, die untereinander elektrisch verbunden sind, eingebettet sind, C) mindestens einer rückseitigen, der Energiequelle abgewandten, äußeren Schicht aus Glas oder einem witterungsstabilen Kunststoff mit niedriger Wasserdampfdurchlässigkeit, dadurch gekennzeichnet, dass die Kunststoffklebeschicht in B) aus einem aliphatischen thermoplastischen Polyurethan mit einer Härte von 75 Shore A bis 70 Shore D und mit einer Erweichungstemperatur Terw von 90°C bis 150°C bei einem E'-Modul von 2 MPa (gemessen nach der DMS-Methode) besteht, welches ein Reaktionsprodukt ist aus einem aliphatischen Diisocyanat (A), mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 600 bis 10000 g/mol (B) und mindestens einem zerewitinoff-aktiven Polyol mit im Mittel mindestens 1,8 bis höchstens 3,0 zerewitinoff-aktiven Wasserstoffatomen und mit einem zahlenmittleren Molekulargewicht von 60 bis 500 g/mol als Kettenverlängerer (C), wobei das Molverhältnis der NCO-Gruppen des aliphatischen Diisocyanats zu den zerewitinoff-aktiven Wasserstoffatomen aus (B) und (C) 0,85 bis 1,2, bevorzugt 0,9 bis 1,1 beträgt.

Die WO 2016/063244 A1 offenbart eine Verbindungsvorrichtung zum elektrischen Verbinden mindestens eines Endabschnitts mindestens eines Längsverbinders mindestens eines Solarzellenstrings mit einem Querverbinder, wobei sich der Längsverbinder vorzugsweise im Wesentlichen in Längsrichtung des Strings erstreckt, wobei die Verbindungsvorrichtung umfasst:
- eine erste Transporteinrichtung, die geeignet ist, den mindestens einen String, vorzugsweise mehrere hintereinander angeordnete Strings, in einer ersten Transportrichtung und mit einer ersten Transportgeschwindigkeit zu transportieren, wobei die erste Transporteinrichtung vorzugsweise ein Förderband ist;
- mindestens eine Zuführstation zum Zuführen eines Querverbinders zu dem Endabschnitt des mindestens einen Längsverbinders
- mindestens eine Verbindungsstation, vorzugsweise eine Schweiß- oder Lötstation, zum elektrischen Verbinden des mindestens einen Endabschnitts des Längsverbinders mit dem Querverbinder; mindestens eine Andrückeinrichtung zum Andrücken des Querverbinders und des Endabschnitts des Längsverbinders gegeneinander, wobei sich mindestens ein Teil der Andrückeinrichtung im Arbeitsbereich der Verbindungsstation erstreckt; wobei sich der Arbeitsbereich der Verbindungsstation und der Andrückbereich der Andrückeinrichtung seitlich entlang des Transportweges der Strings auf dem ersten Transportmittel und/oder in einem seitlichen Bereich des ersten Transportmittels erstrecken.

Die DE 10 2008 046 327 A1 offenbart eine Anordnung mehrerer Produktionsvorrichtungen zu einer Anlage zur Verarbeitung von Solarzellen zu einem Modul, wobei die Anordnung mindestens folgendes aufweist: - mindestens eine Produktionsvorrichtung zum Bereitstellen der Träger; - mindestens eine Produktionsvorrichtung zur Vorkonfektionierung der Solarzellen durch Anbringen von Kontaktdrähten; - mindestens eine Produktionsvorrichtung zum Anordnen von Querkontaktdrähten am Träger bevor die vorkonfektionierten Solarzellen darauf aufgelegt werden; - mindestens eine Produktionsvorrichtung zum Auf legen der vorkonfektionierten Solarzellen auf einen Träger; - mindestens eine Produktionsvorrichtung zum Durchführen der Längsverschaltung der vorkonfektionierten Solarzellen an den Kontaktdrähten nach dem Auflegen der vorkonfektionierten Solarzellen; - mindestens eine Produktionsvorrichtung zum Durchführen der Querverschaltung der vorkonfektionierten Solarzellen an dem Querkontaktdraht nach dem Auflegen der vorkonfektionierten Solarzellen; - mindestens eine Produktionsvorrichtung zum Zusammenführen der an dem Träger befindlichen Solarzellen an ein Trägerglas zur Fertigung des Moduls.

Die US 2019/058436 A1 offenbart ein flexibles photovoltaisches (PV) Modul, das Folgendes umfasst:
eine erste PV-Ziegelbereich; eine zweite PV-Ziegelbereich;
einen dritten PV-Ziegelbereich, wobei der erste PV-Ziegelbereich, der zweite PV-Ziegelbereich und der dritte PV-Ziegelbereich linear angeordnet sind, um ein längliches Modul zu bilden, wobei der erste PV-Ziegelbereich an den zweiten PV-Ziegelbereich und der zweite PV-Ziegelbereich an den dritten PV-Ziegelbereich angrenzt; eine erste flexible Verbindung, die den ersten PV-Ziegelbereich und den zweiten PV-Ziegelbereich elektrisch und strukturell verbindet; eine zweite flexible Verbindung, die den zweiten PV-Ziegelbereich und den dritten PV-Ziegelbereich elektrisch und strukturell verbindet; eine Vielzahl von ersten Stromschienen auf beiden Seiten der ersten und zweiten flexiblen Verbindung, die so ausgelegt sind, dass sie jeden der PV-Ziegelbereiche in einer Reihenschaltung elektrisch miteinander verbinden; und ein Paar zweiter Stromschienen, von denen jeweils eine mit jedem Ende der Reihenschaltung elektrisch verbunden ist und entsprechende V+- und V- Stromausgänge bildet.

Die Druckschrift CN 104 600 141 A1 offenbart ein Solarmodul mit mindestens einem Batteriepaket. Jedes Batteriepaket umfasst mindestens zwei in Reihe geschaltete Batterien; jede Batteriereihe umfasst mindestens zwei parallel geschaltete Zelleinheiten; jede Zelleinheit wird durch Schneiden einer Solarzelle hergestellt; jeweils zwei benachbarte Batteriereihen sind kreuzweise und in Reihe geschaltet. Das Solarmodul ist parallel und in Reihe geschaltet; wenn Schwachstrom-Hotspots auftreten, schaltet eine Zelleinheit ab, und andere Zelleinheiten, die parallel zu dieser Zelleinheit geschaltet sind, laufen weiter. Daher führt die Verwendung der Parallel-Reihenschaltung zu einer Verringerung des Einflusses der Zelleneinheiten auf die Modulleistung, und der Einfluss defekter Zelleneinheiten auf den Wirkungsgrad des gesamten Solarmoduls wird effektiv verringert.

Aufgabe der Erfindung ist es, ein Verfahren zum Herstellen von Solarmodulen und eine entsprechende Vorrichtung bereitzustellen, die die effiziente Herstellung von Solarmodulen begünstigen.

Zur Lösung der Aufgabe wird zunächst ein Verfahren mit den Mitteln und Merkmalen des ersten unabhängigen, auf ein Verfahren zum Herstellen von Solarmodulen gerichteten Anspruchs vorgeschlagen. Insbesondere wird zur Lösung der Aufgabe somit bei dem eingangs genannten Verfahren vorgeschlagen, dass wenigstens zwei Zeilen aufgebaut werden und dass die wenigstens zwei Zeilen gemeinsam einer Bestückung des Solarmoduls zugeführt werden.

Durch die gemeinsame, insbesondere zeitgleiche, Zuführung von zumindest zwei oder mehr Zeilen kann die Bestückung des Solarmoduls in kürzerer Zeit erfolgen, wodurch eine effizientere Herstellung von Solarmodulen begünstigt wird.

Die wenigstens zwei Zeilen werden mittels einer motorisierten Transfereinheit, beispielsweise mittels eines Tabletts und/oder Trays und/oder mittels eines Unterdrucktisches und/oder Bandförderers, gemeinsam der Bestückung des Solarmoduls zugeführt. Die Verwendung einer motorisierten Transfereinheit kann die weitgehend oder sogar vollständig automatisierte Herstellung von Solarmodulen begünstigen.

Für eine Bestückung des Solarmoduls mit den Zeilen ohne eine beim Aufbau der Zeilen erzeugte Anordnung der Photovoltaikzellen in den Zeilen zu verändern, ist es vorteilhaft, wenn eine relative Ausrichtung der Photovoltaikzellen innerhalb einer Zeile und/oder innerhalb zweier unterschiedlicher Zeilen bei der Zuführung erhalten bleibt.

Im fertigen Solarmodul kann innerhalb der einzelnen Zeilen aus Photovoltaikzellen jeweils ein elektrisches Spannungsniveau anliegen. In Längsrichtung der Zeilen findet demnach kein elektrischer Spannungsaufbau über die Photovoltaikzellen einer Zeile hinweg statt. Im fertigen Solarmodul kann ein elektrischer Spannungsaufbau über die elektrisch miteinander verbundenen Zeilen hinweg und damit quer oder rechtwinklig zu einer Längsrichtung der Zeilen erfolgen.

Gemäß dem Verfahren können die Photovoltaikzellen somit zu Zeilen zusammengesetzt werden, wobei innerhalb der einzelnen Zeilen aus Photovoltaikzellen jeweils ein elektrisches Spannungsniveau anliegt. Die Solarmodule können dann aus elektrisch miteinander verbundenen Zeilen aufgebaut werden, wobei ein elektrischer Spannungsaufbau im Solarmodul über die elektrisch miteinander verbundenen Zeilen hinweg und damit quer oder rechtwinklig zu einer Längsrichtung der Zeilen erfolgt.

Im Sinne der beanspruchten Erfindung kann eine Zeile somit von einem konventionellen String aus Photovoltaikzellen zu unterscheiden sein. In einem String sind die Photovoltaikzellen elektrisch so miteinander verbunden, dass ein elektrischer Spannungsaufbau in Längsrichtung des Strings über die elektrisch miteinander verbundenen Photovoltaikzellen des Strings erfolgt.

Zur elektrischen Verbindung von Photovoltaikzellen innerhalb einer Zeile und von Photovoltaikzellen unterschiedlicher, insbesondere benachbarter, Zeilen wird ein elektrischleitfähiger Kleber auf die Photovoltaikzellen aufgebracht.

Um ein Abreißen einer Kleberraupe beim Auftrag des elektrisch-leitfähigen Klebers auf eine Zeile von Photovoltaikzellen zu verhindern, kann es vorteilhaft sein, eine Anzahl von gemeinsam zugeführten Zeilen auf eine Auftragsgeschwindigkeit eines elektrisch leitfähigen Klebers abzustimmen. Insbesondere dann, wenn Photovoltaikzellen mittels einer Übergabeeinheit in zumindest zwei Zeilen angeordnet werden, kann eine maximale Zuführ- oder Transfergeschwindigkeit, mit der die Zeilen der Bestückung des Solarmoduls gemeinsam zugeführt werden, durch die Taktzeit der Übergabeeinheit bei der Anordnung der Photovoltaikzellen begrenzt sein.

Je höher nun die Anzahl gemeinsam zugeführter Zeilen ist, desto geringer kann eine Zuführ- oder Transfergeschwindigkeit sein, mit der die zumindest zwei Zeilen der Bestückung zugeführt werden können. Dann, wenn der elektrisch leitfähige Kleber während der Zuführung der zumindest zwei Zeilen von Photovoltaikzellen zur Bestückung des Solarmoduls aufgetragen werden soll, beispielsweise durch eine Relativbewegung der Zeilen während ihrer Zuführung zur Bestückung des Solarmoduls zu einer Abgabeeinheit, mit der Kleber abgegeben wird, kann es somit zweckmäßig sein, eine Anzahl von gemeinsam zugeführten Zeilen auf die Auftragsgeschwindigkeit des elektrisch-leitfähigen Klebers abzustimmen, um den Auftrag des elektrisch leitfähigen Klebers prozesssicher zu gestalten.

Wenn die Auftragsgeschwindigkeit des elektrisch-leitfähigen Klebers ihrerseits variabel ist, kann auch die Auftragsgeschwindigkeit des elektrisch leitfähigen Klebers auf eine Anzahl von gemeinsam zugeführten Zeilen abgestimmt sein.

Bei einer Ausführungsform des Verfahrens ist vorgesehen, dass eine erste Gruppe gemeinsam zugeführter Zeilen in einem ersten Zyklusabschnitt in einem ersten vertikalen Abstand zu einer Abgabeeinheit für elektrisch leitfähigen Kleber und eine zweite Gruppe gemeinsam zugeführter Zeilen anschließend in einem zweiten, vom ersten vertikalen Abstand verschiedenen zweiten vertikalen Abstand zu der Abgabeeinheit zugeführt werden. Bei dieser Ausführungsform des Verfahrens können somit zwei Transferebenen vorhanden sein, in denen unterschiedliche Gruppen von gemeinsam zugeführten Zeilen der Bestückung von Solarmodulen zugeführt werden. Diese Transferebenen können hierbei vertikal übereinander angeordnet sein, so dass die Transferebenen unterschiedliche vertikaler Abstände zu einem Abgabepunkt, beispielsweise einer Abgabeeinheit, für elektrisch leitfähigen Kleber auf die gemeinsam zugeführten Zeilen aufweisen.

Um eine Verbindung benachbarter Zeilen untereinander zu bewirken, wird erfindungsgemäß elektrisch leitfähiger Kleber mit einem seitlichen Versatz zu einer Längsmittelachse einer Zeile von Photovoltaikzellen auf eine Zeile aufgebracht. Auf diese Weise werden zwei benachbarte Zeilen erfindungsgemäß sich gegenseitig überlappend miteinander verklebt.

Ferner werden erfindungsgemäß beim Aufbau der Zeilen Versatzstücke verwendet, um einen Versatz benachbarter Zeilen zueinander zu bilden.

Der Versatz benachbarter Zeilen zueinander kann vorteilhaft sein, um eine mechanisch sichere und stabile Verbindung zwischen benachbarten Zeilen innerhalb eines Solarmoduls zu erzeugen.

Die Verwendung von relativ zueinander versetzten Zeilen von Photovoltaikzellen in einem Solarmodul bietet die Möglichkeit, eine Photovoltaikzelle einer Zeile mit mehreren die Photovoltaikzelle am Solarmodul umgebenden Photovoltaikzellen derselben und/oder benachbarter Zeilen elektrisch zu verbinden. Dies kann dazu führen, dass ein derartig aufgebautes Solarmodul auch bei Verschattung einzelner oder mehrerer Photovoltaikzellen des Solarmoduls eine hohe Leistung bringt.

Wenn der Versatz benachbarter Zeilen zueinander bereits vor der Bestückung des Solarmoduls beim Aufbau der Zeilen von Photovoltaikzellen erzeugt wird, kann ein Handling der Zeilen bei Bestückung des Solarmoduls erheblich vereinfacht sein. Dies kann die Effizienz des Verfahrens bei der Herstellung von Solarmodulen erheblich steigern.

Als Versatzstücke können beispielsweise Photovoltaikzellen verwendet werden, die im Vergleich zu anderen Photovoltaikzellen einer Zeile eine kürzere Länge und/oder eine andere Geometrie aufweisen.

Erfindungsgemäß werden bei dem Verfahren somit, wenigstens zwei zueinander versetzte Zeilen zur Bestückung gemeinsam zugeführt.

Die Photovoltaikzellen, die zu Zeilen zusammengesetzt werden, können so genannte Photovoltaikzellen-Schindeln sein.

Bei einer Ausführungsform des Verfahrens werden zeitlich parallel Gruppen von wenigstens zwei Zeilen aufgebaut, die einer gemeinsamen Bestückung zugeführt werden. Auf diese Weise kann die Anzahl von gemeinsam zugeführten Zeilen durch Skalierung des Verfahrens erhöht werden.

Zur Lösung der Aufgabe wird auch eine Vorrichtung zur Herstellung von Solarmodulen vorgeschlagen, die die Mittelmerkmale des unabhängigen, auf eine derartige Vorrichtung gerichteten Anspruchs aufweist. Zur Lösung der Aufgabe wird somit bei der eingangs definierten Vorrichtung insbesondere vorgeschlagen, dass diese Vorrichtung Mittel aufweist, durch die Vorrichtung zur Durchführung eines Verfahrens nach einem der auf ein Verfahren zum Herstellen von Solarmodulen gerichteten Ansprüche eingerichtet ist.

Erfindungsgemäß ist vorgesehen, dass die Vorrichtung als Mittel zur Durchführung des Verfahrens eine motorisierte Transfereinheit aufweist, mit der zumindest zwei Zeilen von Photovoltaikzellen gemeinsam einer Bestückung eines herzustellenden Solarmoduls zuführbar sind.

Als motorisierte Transfereinheit kann beispielsweise ein Tablett (Tray), ein Fördertisch, insbesondere mit Unterdrucktisch, ein Bandförderer, insbesondere mit Unterdrucktisch und/oder ein Unterdrucktisch dienen. Mithilfe eines Unterdrucktischs ist es möglich, auf dem Unterdrucktisch in Zeilen angeordnete Photovoltaikzellen während der Zuführung zur Bestückung durch Unterdruck zu fixieren. Die Fixierung von Photovoltaikzellen mittels Unterdrucks ist besonders schonend und kann helfen, Ausschuss bei der Herstellung von Solarmodulen zu reduzieren oder gar vollständig zu vermeiden.

Die motorisierte Transfereinheit kann dazu eingerichtet sein, die Photovoltaikzellen der Zeilen von einem Beladepunkt in einen Entladepunkt zu bewegen, an dem die Zeilen von Photovoltaikzellen zur Bestückung eines Solarmoduls von der Transfereinheit entfernt werden.

An der Transfereinheit können zumindest zwei Auflageplätze für jeweils eine Zeile von Photovoltaikzellen ausgebildet und/oder definiert sein. Auf diese Weise ist es möglich, mit der Transfereinheit zumindest zwei Zeilen von Photovoltaikzellen gemeinsam einer Bestückung von Solarmodulen zuzuführen.

Bei einer bevorzugten Ausführungsform der Vorrichtung kann die Transfereinheit für jeden Auflageplatz zumindest eine Reihe von Ansaugöffnungen aufweist. Auf diese Weise können auf den zumindest zwei Auflageplätzen der Transfereinheit angeordnete Reihen von Photovoltaikzellen mittels Unterdrucks an der Transfereinheit fixiert werden.

Die Vorrichtung kann eine Unterdruckerzeugungseinheit aufweisen, mit der Zeilen von Photovoltaikzellen durch Unterdruck an der Transfereinheit fixierbar sind, dies insbesondere während der gemeinsamen Zuführung von zumindest zwei Zeilen zur Bestückung eines Solarmoduls. Wie zuvor bereits erwähnt, ermöglicht die Verwendung von Unterdruck zur Fixierung der Zeilen eine besonders schonende und daher effiziente Fixierung von Photovoltaikzellen während ihrer Zuführung an der Transfereinheit.

Die Unterdruckerzeugungseinheit kann hierbei mit Ansaugöffnungen der Transfereinheit verbunden sein. Über die Ansaugöffnungen der Transfereinheit kann der von der Unterdruckerzeugungseinheit erzeugte Unterdruck auf die Zeilen von Photovoltaikzellen übertragen werden.

Die Vorrichtung weist erfindungsgemäß als Mittel zur Durchführung des Verfahrens ferner eine Abgabeeinheit zur Abgabe von elektrisch leitfähigem Kleber auf Zeilen von Photovoltaikzellen auf. Die Abgabeeinheit kann so angeordnet sein, dass eine Abgabe von elektrisch leitfähigem Kleber auf Zeilen von Photovoltaikzellen möglich ist, die auf der Transfereinheit angeordnet sind. Die Abgabeeinheit kann beispielsweise zwischen einem Beladepunkt, an dem die Photovoltaikzellen zum Aufbau von Zeilen auf der zuvor erwähnte Transfereinheit angeordnet werden, und einem Entladepunkt, an dem die Zeilen von der Transfereinheit entladen werden, angeordnet sein. Auf diese Weise ist es möglich, den elektrisch leitfähigen Kleber mithilfe der Abgabeeinheit durch eine Relativbewegung zwischen Abgabeeinheit und Transfereinheit auf die Zeilen von Photovoltaikzellen aufzutragen. Die Zeilen können somit während ihres Transfers zwischen dem Beladepunkt und dem Entladepunkt mit elektrisch leitfähigem Kleber versehen werden. Gegebenenfalls kann die Relativbewegung hierbei die Transferbewegung der Zeilen sein.

Die Abgabeeinheit kann eine Anzahl von Abgabedüsen aufweisen, die einer Anzahl von Auflageplätzen für Zeilen von Photovoltaikzellen der Transfereinheit entspricht. Auf diese Weise ist es möglich, sämtliche Zeilen von Photovoltaikzellen, die auf der Transfereinheit während des Transfers angeordnet sind, mit elektrisch-leitfähigen Kleber zu versehen.

Bei einer Ausführungsform der Vorrichtung ist vorgesehen, dass die Abgabeeinheit, insbesondere zumindest eine Abgabedüse der Abgabeeinheit, aus der elektrisch leitfähiger Kleber auf Zeilen von Photovoltaikzellen aufgetragen werden kann, in Längsrichtung von Auflageplätzen der Transfereinheit für Zeilen und damit in Längsrichtung von auf der Transfereinheit angeordneten Zeilen verfahrbar ist. Dies ermöglicht es, elektrisch leitfähigen Kleber auf Zeilen von Photovoltaikzellen aufzubringen, die mithilfe einer Transfereinheit der Bestückung zugeführt werden, wobei die Transfereinheit eine Transferbewegung ausführt, die quer oder rechtwinklig zur Längsrichtung der auf der Transfereinheit angeordneten Zeilen von Photovoltaikzellen ausgerichtet ist. Hierbei kann die Bewegung der Abgabeeinheit, insbesondere ihrer Abgabedüsen, dann quer oder entsprechend rechtwinklig zur Transferbewegung der Transfereinheit ausgerichtet sein.

Die Vorrichtung kann ein Magazin zur Bereitstellung von Photovoltaikzellen aufweisen. Das Magazin kann beispielsweise ein Fördermittel, beispielsweise ein Förderband, umfassen, auf dem ein Vorrat von Photovoltaikzellen und/oder Versatzstücken, in eine Entnahmeposition bewegt werden kann. Dies begünstigt eine besonders effiziente und weitgehend unterbrechungsfreie Bereitstellung von Photovoltaikzellen für die Herstellung von Solarmodulen.

Die Vorrichtung kann zudem eine Übergabeeinheit, insbesondere mit einem Handhabungsroboter, beispielsweise einen Schwenkarmroboter, aufweisen, mit der Photovoltaikzellen auf der Transfereinheit in Zeilen angeordnet werden können.

Mithilfe der Übergabeeinheit können die Photovoltaikzellen und/oder Versatzstücke beispielsweise aus dem zuvor bereits erwähnten Magazin entnommen werden.

Die Übergabeeinheit, insbesondere der zuvor erwähnte Handhabungsroboter, kann hierbei zumindest einen Sauggreifer aufweisen. Mithilfe eines Sauggreifers können Photovoltaikzellen besonders schonend gegriffen und auch wieder abgegeben werden.

Zur Kontrolle von Photovoltaikzellen kann die Vorrichtung eine Kontrolleinheit aufweisen. Die Kontrolleinheit kann zumindest ein optisches Kontrollmittel, beispielsweise eine Kamera umfassen. Bei einer Ausführungsform der Vorrichtung ist die Kontrolleinheit zwischen einem Magazin zur Bereitstellung von Photovoltaikzellen und der Transfereinheit, insbesondere zwischen dem Magazin zur Bereitstellung von Photovoltaikzellen und der zuvor bereits erwähnten Übergabeeinheit der Vorrichtung, mit der Photovoltaikzellen aus dem Magazin entnommen und auf der Transfereinheit in Zeilen angeordnet werden können, vorgesehen. Dies ermöglicht, die aus dem Magazin ausgefassten Photovoltaikzellen vor ihrer Anordnung in Zeilen auf der Transfereinheit zu prüfen.

Das Magazin kann zumindest einen Bandförderer umfassen, mit dem die Photovoltaikzellen in eine Entnahmeposition gebracht werden können.

Die Vorrichtung kann ferner eine Bestückungseinheit, insbesondere mit zumindest einem Greifer, vorzugsweise mit zumindest einem Sauggreifer, aufweisen. Die Bestückungseinheit kann dazu eingerichtet sein, zumindest eine oder mehrere oder alle Zeilen von Photovoltaikzellen, die von der Transfereinheit in einem Entladepunkt bereitgestellt werden, aufzunehmen und/oder an einen nachgelagerten Bearbeitungsschritt und/oder Handhabungsschritt, insbesondere an eine nachgelagerte Transporteinheit der Vorrichtung zu übergeben. Mithilfe der Bestückungseinheit ist es möglich, das Solarmodul mit den von der Transfereinheit bereitgestellten Zeilen von Photovoltaikzellen zu bestücken.

Die Vorrichtung kann eine der Transfereinheit nachgelagerte Transporteinheit aufweisen. Mithilfe der Transporteinheit kann zumindest ein mit Zeilen von Photovoltaikzellen bestücktes Solarmodul einer nachgelagerte Bearbeitungsstation zugeführt werden. Eine nachgelagerte Bearbeitungsstation kann beispielsweise ein Ofen sein, in dem elektrisch leitfähiger Kleber ausgehärtet wird, der zur Verbindung der Zeilen von Photovoltaikzellen eines Moduls untereinander verwendet werden kann. Eine nachgelagerte Bearbeitungsstation kann beispielsweise auch eine Verpackungs- und/oder Verladestation sein. Als Verpackungs- und/oder Verladestation kann beispielsweise ein Layup verwendet werden, das zur Matrix-Umlegung eingerichtet sein kann.

Bei einer Ausführungsform der Vorrichtung ist vorgesehen, dass eine Transferbewegung der Transfereinheit quer, insbesondere rechtwinklig, zu einer Längsrichtung von Auflageplätzen für Zeilen von Photovoltaikzellen auf der Transfereinheit oder in Längsrichtung von Auflageplätzen für Zeilen auf der Transfereinheit ausgerichtet ist.

Bei einer Ausführungsform der Vorrichtung ist vorgesehen, dass eine Transferbewegung der Transfereinheit quer, insbesondere rechtwinklig, zu einer Transportbewegung der Transporteinheit ausgerichtet ist. Bei einer anderen Ausführungsform der Vorrichtung ist vorgesehen, dass eine Transferbewegung der Transfereinheit in Richtung einer Transportbewegung der Transporteinheit ausgerichtet ist. Bei dieser Ausführungsform der Vorrichtung kann es vorteilhaft sein, wenn die zuvor erwähnte Abgabeeinheit, zumindest wenigstens eine Abgabedüse der Abgabeeinheit, mit der elektrisch leitfähiger Kleber auf die Zeilen von Photovoltaikzellen aufgebracht werden kann, relativ zu der Transfereinheit und in Längsrichtung der Auflageplätze für Zeilen und damit in Längsrichtung der Zeilen von Photovoltaikzellen, die auf der Transfereinheit angeordnet sind, und/oder relativ zu der Transfereinheit und quer oder rechtwinklig zu den Auflageplätzen und/oder den Zeilen von Photovoltaikzellen bewegt werden kann.

Die Vorrichtung weist als Mittel zur Durchführung des Verfahrens ferner eine Steuereinheit auf, durch die die Vorrichtung zur Durchführung des Verfahrens noch eine der auf einen solches gerichteten Ansprüche eingerichtet ist.

Die Erfindung wird nachfolgend anhand von Ausführungsbeispielen näher beschrieben, ist aber nicht auf die gezeigten Ausführungsbeispiele beschränkt. Weitere Ausführungsbeispiele ergeben sich durch Kombination der Merkmale einzelner oder mehrerer Schutzansprüche untereinander und/oder in Kombination einzelner oder mehrerer Merkmale der Ausführungsbeispiele.

Es zeigen:

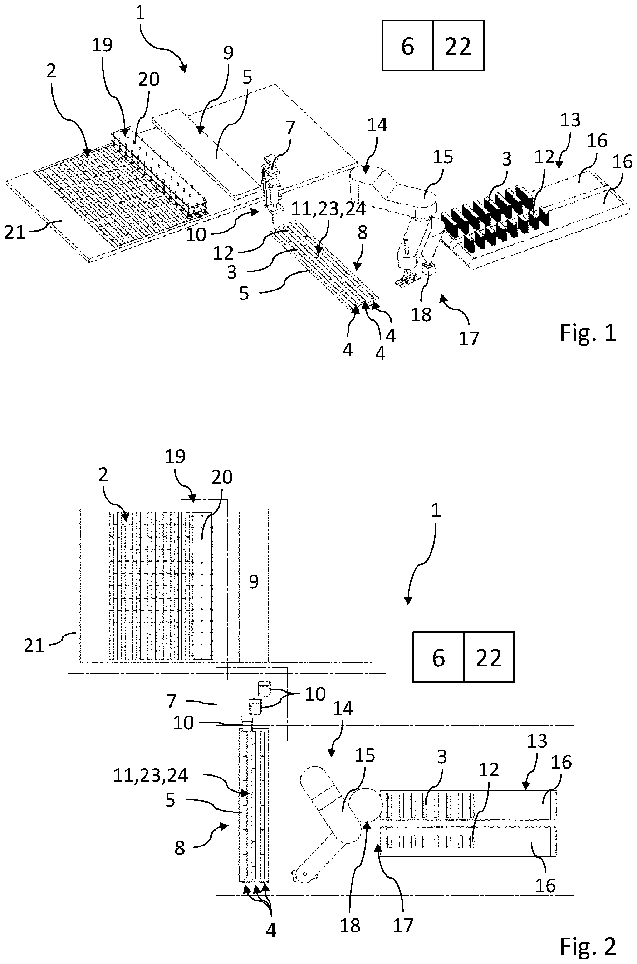

- Figuren 1 und 2: ein erstes Ausführungsbeispiel einer Vorrichtung zum Herstellen von Solarmodulen, wobei die Vorrichtung eine Transfereinheit in Form eines bewegbaren Unterdrucktisches, der auch als Tray bezeichnet werden kann, aufweist, mit dem insgesamt drei Zeilen von Photovoltaikzellen gemeinsam zur Bestückung eines Solarmoduls mit den Zeilen in eine Entladeposition überführt werden können,

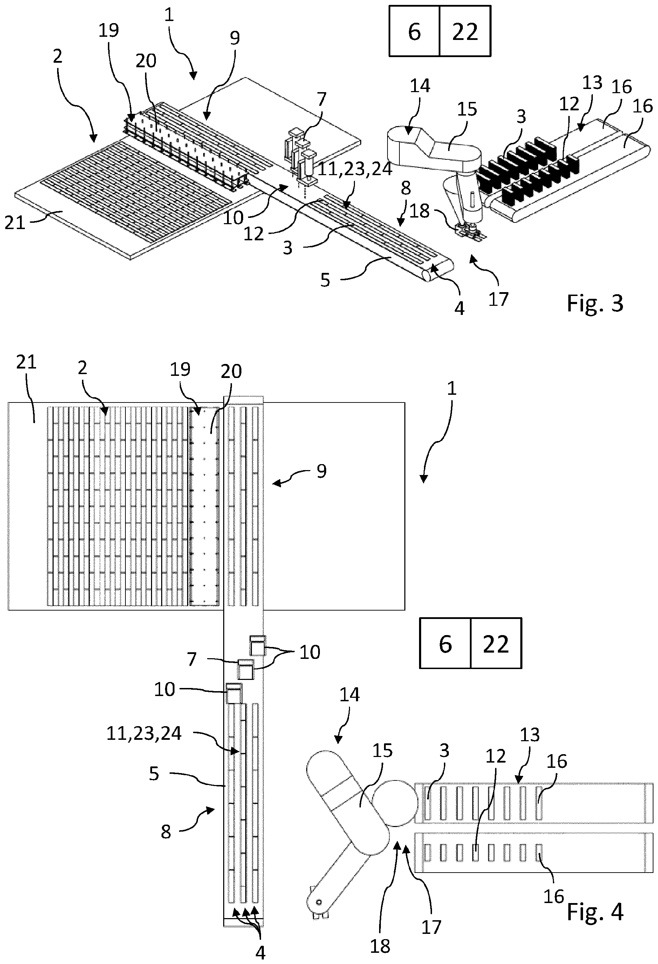

- Figuren 3 und 4: eine zweites Ausführungsbeispiel einer Vorrichtung zum Herstellen von Solarmodulen, wobei hier eine Transfereinheit der Vorrichtung, mit der drei Zeilen von Photovoltaikzellen gemeinsam der Bestückung eines Solarmoduls zugeführt werden können, als Bandförderer ausgebildet ist, sowie

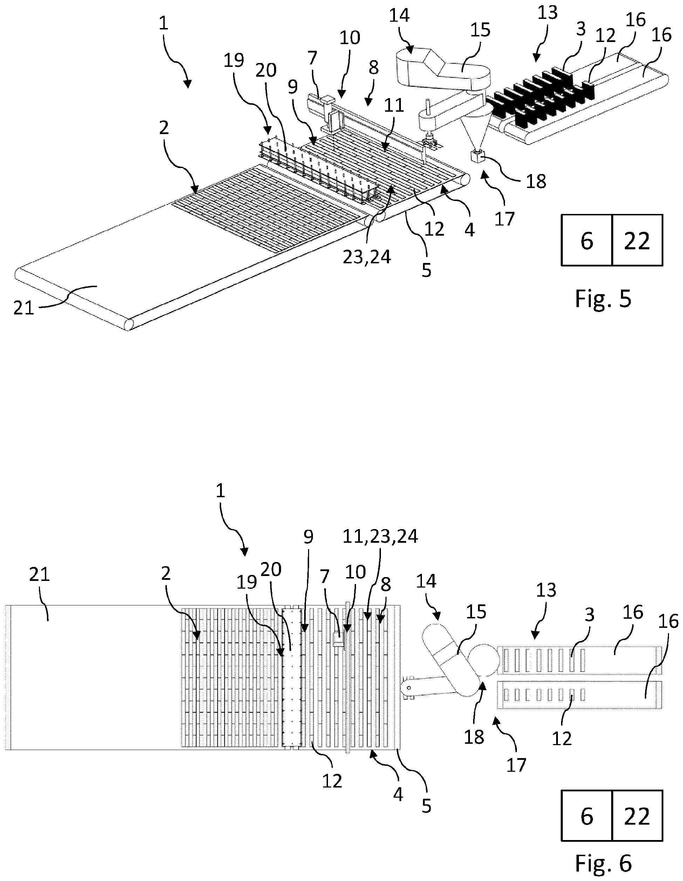

- Figuren 5 und 6: ein drittes Ausführungsbeispiel einer Vorrichtung zum Herstellen von Solarmodulen, wobei diese Vorrichtung ebenfalls eine Transfereinheit in Form eines Bandförderers aufweist, wobei allerdings hier eine Transferbewegung der Transfereinheit quer, nämlich rechtwinklig, zur Orientierung der auf der Transfereinheit angeordneten Zeilen von Photovoltaikzellen ausgerichtet ist.

Bei der nachfolgenden Beschreibung verschiedener Ausführungsformen der Erfindung erhalten in ihrer Funktion übereinstimmende Elemente auch bei abweichender Gestaltung oder Formgebung übereinstimmende Bezugszahlen.

Sämtliche Figuren zeigen jeweils eine im Ganzen mit 1 bezeichnete Vorrichtung zur Herstellung von Solarmodulen 2.

Jede Vorrichtung 1 weist Mittel auf, durch die die Vorrichtung 1 zur Durchführung des nachfolgend beschriebenen Verfahrens zum Herstellen von Solarmodulen 2 eingerichtet ist.

Hierbei werden Photovoltaikzellen 3 zu Zeilen 4 zusammengesetzt und Solarmodule 2 aus den dann elektrisch miteinander verbundenen Zeilen 4 aufgebaut.

Bei dem Verfahren ist vorgesehen, dass zumindest zwei Zeilen 4, bei den in den Figuren gezeigten Beispielen zumindest drei Zeilen 4, aufgebaut werden und dass die Zeilen 4 dann gemeinsam einer Bestückung eines Solarmoduls 2 zugeführt werden.

Bei sämtlichen in den Figuren gezeigten Ausführungsbeispielen von Vorrichtungen 1 werden die Zeilen 4 mittels jeweils einer motorisierten Transfereinheit 5 gemeinsam zur Bestückung des Solarmoduls 2 zugeführt.

Bei dem in den Figuren 1 und 2 dargestellten Ausführungsbeispiel einer solchen Vorrichtung 1 wird als Transfereinheit 5 ein Unterdrucktisch verwendet, der zwischen einem Beladepunkt 8 und einem Entladepunkt 9 bewegbar ist.

Die in den Figuren 3 und 4 gezeigte Vorrichtung 1 weist als Transfereinheit 5 einen Bandförderer auf. Durch die Transferbewegung des Bandförderers können die Zeilen 4, die auf dem Bandförderer aufgebaut werden, gemeinsam der Bestückung des Solarmoduls 2 zugeführt werden.

Die in den Figuren 5 und 6 gezeigte Vorrichtung 1 ist ebenfalls mit einer Transfereinheit 5 ausgestattet, die als Bandförderer ausgebildet ist.

Während bei der in den Figuren 3 und 4 dargestellten Vorrichtung 1 eine Transferbewegung der Transfereinheit 5 in Längsrichtung der auf der Transfereinheit 5 angeordneten Zeilen 4 erfolgt, ist die Transferbewegung der Transfereinheit 5 der in den Figuren 5 und 6 dargestellten Vorrichtung 1 quer, nämlich rechtwinklig zur Längsrichtung der auf der Transfereinheit 5 aufgebauten Zeilen 4 von Photovoltaikzellen 3 ausgerichtet.

Bei dem Verfahren, das auf allen drei gezeigten Ausführungsbeispielen von Vorrichtungen 1 durchgeführt werden kann, ist vorgesehen, dass eine relative Ausrichtung der Photovoltaikzellen 3 innerhalb einer Zeile 4 und auch der Zeilen 4 zueinander, die auf der Transfereinheit 5 aufgebaut werden, bei der Zuführung erhalten bleiben.

Eine Anzahl von gemeinsam zugeführten Zeilen 4 ist hierbei auf eine Auftragsgeschwindigkeit eines elektrisch leitfähigen Klebers abgestimmt. Der elektrisch leitfähige Kleber wird auf die Zeilen 4 von Photovoltaikzellen 3 aufgetragen, um die Photovoltaikzellen 3 und Zeilen 4 untereinander mechanisch und elektrisch zu verbinden. Der Auftrag des elektrisch leitfähigen Klebers auf eine Zeile 4 von Photovoltaikzellen 3 kann hierbei mit einem seitlichen Versatz zur Längsmittelachse einer jeweiligen Zeile 4 erfolgen.

Jede der in den Figuren gezeigten Vorrichtungen 1 weist jeweils eine Unterdruckerzeugungseinheit 6 auf, mit der Zeilen 4 von Photovoltaikzellen 3 durch Unterdruck an der jeweiligen Transfereinheit 5 zumindest zeitweise fixierbar sind. Die Unterdruckerzeugungseinheiten 6 sind in den Figuren nur stark schematisiert dargestellt.

Jede gezeigte Vorrichtung 1 weist ferner eine Abgabeeinheit 7 zur Abgabe von elektrisch leitfähigem Kleber auf Zeilen 4 von Photovoltaikzellen 3 auf, die auf der Transfereinheit 5 angeordnet sind.

Die Abgabeeinheiten 7 der Vorrichtungen 1 sind jeweils zwischen dem bereits zuvor erwähnten Beladepunkt 8 und dem zuvor ebenfalls erwähnten Entladepunkt 9 von Zeilen 4 angeordnet.

Die Abgabeeinheit 7 der in den Figuren 1 und 2 sowie 3 und 4 gezeigten Vorrichtung 1 weisen eine Anzahl von Abgabedüsen 10 auf, die einer Anzahl von Auflageplätzen 11 für Zeilen 4 von Photovoltaikzellen 3 an der Transfereinheit 5 entspricht. Folgerichtig weisen die Abgabeeinheit 7 der in den Figuren 1-4 gezeigten Vorrichtungen 1 somit jeweils drei Abgabedüsen 10 auf. Senkrechte Projektionen der Abgabedüsen 10 auf zumindest zeitweise darunter angeordnete Auflageplätze 11 für Photovoltaikzellen 2 an den Transfereinheiten 5 können einen seitlichen Versatz zu Längsmittelachsen der Auflageplätze 11 aufweisen. Dies erlaubt den Auftrag von elektrisch leitfähigem Kleber mit seitlichem Versatz zu einer Längsmittelachse der Zeilen 4 auf die Zeilen 4.

Die Unterdruckerzeugungseinheiten 6 der Vorrichtungen 1 sind mit Ansaugöffnungen 23 verbunden, die die jeweilige Transfereinheit 5 aufweist. Jede Transfereinheit 5 weist für jeden ihrer Auflageplätze 11 jeweils wenigstens eine Reihe 24 derartiger Ansaugöffnungen 23 auf. Auf diese Weise können die Zeilen 4 von Photovoltaikzellen 3 während ihrer Zuführung zuverlässig an den Transfereinheiten 5 fixiert werden.

Bei dem in den Figuren 5 und 6 gezeigten Ausführungsbeispiel einer Vorrichtung 1 zur Herstellung von Solarmodulen 2 verfügt die Abgabeeinheit 7 über eine Abgabedüse 10, die in Längsrichtung von auf der Transfereinheit 5 angeordneten Zeilen 4 von Photovoltaikzellen 3 verfahrbar ist. Durch die Bewegung der Abgabedüse 10 entlang der auf der Transfereinheit 5 angeordneten Zeilen 4 kann der elektrisch-leitfähige Kleber auf die unterhalb der Abgabeeinheit 7 zumindest zeitweise angeordneten Zeilen 4 zeilenweise abgegeben werden. Eine Spur, entlang der die Abgabedüse 10 während der Abgabe von elektrisch leitfähigem Kleber verfahrbar sein kann, kann hierbei einen seitlichen Versatz zu einer Längsmittelachse einer mit elektrisch leitfähigem Kleber zu versehenen Zeile 4 aufweisen.

Während der Abgabe von elektrisch leitfähigem Kleber kann Position der Abgabedüse 10 quer zur Längserstreckung der mit elektrisch leitfähigem Kleber zu versehenen Zeile 4 konstant gehalten werden. In diesem Zusammenhang kann vorgesehen sein, dass die Abgabedüse 10 in Richtung der Transferbewegung der Transfereinheit 5 mit der Transfereinheit 5 synchron bewegbar ist.

Bei sämtlichen der in den Figuren gezeigten Vorrichtungen 1 werden beim Aufbau der Zeilen 4 Versatzstücke 12 verwendet, um einen Versatz benachbarter Zeilen 4 zunächst an der jeweiligen Transfereinheit 5 und später auch an dem fertigbestückten Solarmodul 2 zu erzeugen.

Die Versatzstücke 12 sind Photovoltaikzellen, die im Vergleich zu anderen Photovoltaikzellen, die in den Figuren mit 3 bezeichnet werden und die nicht als Versatzstücke 12 ausgebildet sind, eine kürzere Länge aufweisen.

Die Figuren zeigen, dass zumindest zwei, nämlich drei oder sogar mehr zueinander versetzte Zeilen 4 zur Bestückung eines Solarmoduls 2 gemeinsam zugeführt werden.

Bei einer Ausführungsform des Verfahrens können zeitlich parallel Gruppen von wenigstens zwei Zeilen 4 aufgebaut werden, die einer gemeinsamen Bestückung gemeinsam zugeführt werden.

Auch hierfür kann eine der in den Figuren gezeigten Transfereinheit 5 verwendet werden.

Zur Bereitstellung der Photovoltaikzellen 3 und der Versatzstücke 12 weist jede der in den Figuren gezeigten Vorrichtungen 1 ein Magazin 13 auf. Mithilfe einer Übergabeeinheit 14, die einen Handhabungsroboter 15, nämlich einen Schwenkarmroboter, aufweist, können die in dem jeweiligen Magazin 13 bevorrateten und bereitgestellten Versatzstücke 12 und Photovoltaikzellen 3 entnommen und auf der jeweiligen Transfereinheit 5 in Zeilen 4 angeordnet werden. Jedes Magazin 13 weist insgesamt zwei Förderbänder 16 auf, auf denen einerseits die Versatzstücke 12 und andererseits die im Vergleich dazu etwas längeren, regulären Photovoltaikzellen 3 in Stapeln angeordnet bevorratet sind.

Zur Kontrolle von Photovoltaikzellen 3 und auch Versatzstücken 12 weist jede Vorrichtung 1 eine Kontrolleinheit 17 auf. Die Kontrolleinheiten 17 sind zwischen dem Magazin 13 und der Übergabeeinheit 14 der jeweiligen Vorrichtung 1 angeordnet und umfassen jeweils zumindest ein optisches Kontrollmittel, beispielsweise eine Kamera 18.

Mithilfe des Handhabungsroboters 15 der Übergabeeinheit 14 können die aus dem Magazin 13 ausgefassten Photovoltaikzellen 3 und/oder Versatzstücke 12 der Kamera 18 der Kontrolleinheit 17 präsentiert werden, um die Photovoltaikzellen 3 und Versatzstücke 12 vor ihrer Anordnung auf der jeweiligen Transfereinheit 5 zu prüfen. Der jeweiligen Transfereinheit 5 und auch dem Entladepunkt 9 nachgelagert weist jede der Vorrichtungen 1 eine Bestückungseinheit 19 auf. Jede Bestückungseinheit 19 umfasst mehrere Greifer 20, die als Sauggreifer ausgebildet sind.

Die Bestückungseinheiten 19 sind dazu eingerichtet, eine oder mehrere oder auch sämtliche Zeilen 4 von Photovoltaikzellen 3, die von der jeweiligen Transfereinheit 5 am Entladepunkt 9 bereitgestellt werden, aufzunehmen und an eine nachgelagerte Transporteinheit 21 der jeweiligen Vorrichtung 1 zu übergeben. Die jeweilige Transporteinheit 21 dient dazu, zumindest ein mit Zeilen 4 von Photovoltaikzellen 3, 12 bestücktes Solarmodul 2 einer nachgelagerten Bearbeitungsstation, beispielsweise einem Ofen, zuzuführen.

Wie bereits zuvor erwähnt, ist eine Transferbewegung der Transfereinheit 5 der in den Figuren 1-4 gezeigten Vorrichtungen 1 in Längsrichtung von Auflageplätzen 11 und damit auch in Längsrichtung von Zeilen 4 auf der Transfereinheit 5 ausgerichtet.

Bei dem in den Figuren 5 und 6 gezeigten Ausführungsbeispiel der Vorrichtung 1 ist die Transferbewegung der Transfereinheit 5 quer, nämlich rechtwinklig zu einer Längsrichtung von Auflageplätzen 11 und damit quer, nämlich rechtwinklig zu einer Längsrichtung der Zeilen 4, die auf den Auflageplätzen 11 der Transfereinheit 5 angeordnet sind, ausgerichtet.

Die Transferbewegungen der Transfereinheit 5 der in den Figuren 1-4 gezeigten Vorrichtungen 1 sind quer, nämlich rechtwinklig zur Transportbewegung der jeweiligen Transporteinheit 21, die der Transfereinheit 5 nachgelagert ist, ausgerichtet.

Bei dem in den Figuren 5 und 6 gezeigten Ausführungsbeispiel der Vorrichtung 1 ist die Transferbewegung der Transfereinheit 5 in Richtung einer Transportbewegung der dort verwendeten Transporteinheit 21 ausgerichtet.

Die Transporteinheit 21 der in den Figuren 5 und 6 dargestellten Vorrichtung 1 ist, ebenso wie die Transfereinheit 5, als Bandförderer ausgebildet.

Zur Durchführung des zuvor beschriebenen Verfahrens weist jede der in den Figuren gezeigten Vorrichtungen 1 ferner eine Steuereinheit 22 auf. Durch diese Steuereinheit 22 können die zuvor erwähnten Funktionseinheiten der jeweiligen Vorrichtung 1 so angesteuert werden, wie es das Verfahren vorsieht.

Die Erfindung befasst sich mit Verbesserungen auf dem technischen Gebiet der Herstellung von Solarmodulen. Hierzu wird unter anderem ein Verfahren zum Herstellen von Solarmodulen 2 vorgeschlagen, bei dem zumindest zwei oder mehr Zeilen 4 aus Photovoltaikzellen 3 gemeinsam einer Bestückung eines Solarmoduls 2 zugeführt werden.

### Bezugszeichenliste

- 1: Vorrichtung
- 2: Solarmodul
- 3: Photovoltaikzelle
- 4: Zeile
- 5: Transfereinheit
- 6: Unterdruckerzeugungseinheit
- 7: Abgabeeinheit
- 8: Beladepunkt
- 9: Entladepunkt
- 10: Abgabedüse
- 11: Auflageplatz
- 12: Versatzstück
- 13: Magazin
- 14: Übergabeeinheit
- 15: Handhabungsroboter
- 16: Förderband
- 17: Kontrolleinheit
- 18: Kamera
- 19: Bestückungseinheit
- 20: Greifer
- 21: Transporteinheit
- 22: Steuereinheit
- 23: Ansaugöffnung
- 24: Reihe von 23

## Patentansprüche

1. Verfahren zum Herstellen von Solarmodulen (2), wobei Photovoltaikzellen (3) zu Zeilen (4) zusammengesetzt werden und wobei die Solarmodule (2) aus elektrisch miteinander verbundenen Zeilen (4) aufgebaut werden,
wobei wenigstens zwei zueinander versetzte Zeilen (4) aufgebaut und gemeinsam einer Bestückung des Solarmoduls (2) zugeführt werden, wobei beim Aufbau der Zeilen (4) Versatzstücke (12) verwendet werden, um einen Versatz benachbarter Zeilen (4) zueinander zu bilden, und wobei zur Verbindung benachbarter Zeilen (4) von Photovoltaikzellen (3) elektrisch leitfähiger Kleber mit einem seitlichen Versatz zu einer Längsmittelachse einer Zeile (4) von Photovoltaikzellen (3) auf die Zeile (4) aufgebracht wird, wonach zwei benachbarte Zeilen (4) sich gegenseitig überlappend miteinander verklebt werden.

2. Verfahren nach Anspruch 1, **dadurch gekennzeichnet, dass** die wenigstens zwei Zeilen (4) mittels einer motorisierten Transfereinheit (5), insbesondere mittels eines Tabletts und/oder Tisches und/oder mittels eines Bandförderers und/oder mittels eines Unterdrucktischs, gemeinsam der Bestückung des Solarmoduls (2) zugeführt werden.

3. Verfahren nach einem der vorangehenden Ansprüche, **dadurch gekennzeichnet, dass** eine relative Ausrichtung der Photovoltaikzellen (3) innerhalb einer Zeile (4) und/oder zweier unterschiedlicher Zeilen (4) bei der Zuführung erhalten bleibt.

4. Verfahren nach einem der vorangehenden Ansprüche, **dadurch gekennzeichnet, dass** eine Anzahl von gemeinsam zugeführten Zeilen (4) auf eine Auftragsgeschwindigkeit eines elektrisch leitfähigen Klebers abgestimmt ist und/oder dass eine Auftragsgeschwindigkeit eines elektrisch leitfähigen Klebers auf eine Anzahl von gemeinsam zugeführten Zeilen abgestimmt ist.

5. Verfahren nach einem der vorangehenden Ansprüche, **dadurch gekennzeichnet, dass** zeitlich parallel Gruppen von wenigstens zwei Zeilen (4) aufgebaut werden, die einer gemeinsamen Bestückung zugeführt werden.

6. Vorrichtung (1) zur Herstellung von Solarmodulen (2), wobei die Vorrichtung (1) Mittel aufweist, durch die die Vorrichtung (1) zur Durchführung eines Verfahrens nach einem der vorangehenden Ansprüche eingerichtet ist, nämlich eine motorisierte Transfereinheit (5), mit der zumindest zwei Zeilen (4) von Photovoltaikzellen (3) gemeinsam einer Bestückung eines herzustellenden Solarmoduls (2) zuführbar sind, und eine Abgabeeinheit (7) zur Abgabe von elektrisch leitfähigem Kleber auf Zeilen (4) von Photovoltaikzellen (3) und eine Steuereinheit (22), durch die die Vorrichtung (1) zur Durchführung des Verfahrens nach einem der vorangehenden Ansprüche eingerichtet ist.

7. Vorrichtung (1) nach Anspruch 6, wobei die Vorrichtung die motorisierte Transfereinheit (5), nämlich ein Tablett und/oder einen Tisch und/oder einen Bandförderer und/oder einen Unterdrucktisch, aufweist, und vorzugsweise wobei die motorisierte Transfereinheit (5) dazu eingerichtet ist, die Photovoltaikzellen (3) der Zeilen (4) von einem Beladepunkt (8) zu einem Entladepunkt (9) zu bewegen.

8. Vorrichtung (1) nach dem vorangehenden Anspruch, wobei die Transfereinheit (5) zumindest zwei Auflageplätze (11) für Zeilen (4) von Photovoltaikzellen (3) aufweist, vorzugsweise wobei die Transfereinheit für jeden Auflageplatz (11) zumindest eine Reihe (24) von Ansaugöffnungen (23) aufweist.

9. Vorrichtung (1) nach Anspruch 6 bis 8, wobei die Vorrichtung (1) eine Unterdruckerzeugungseinheit (6) aufweist, mit der Zeilen (4) von Photovoltaikzellen (3) durch Unterdruck an der Transfereinheit (5) fixierbar sind, insbesondere wobei die Unterdruckerzeugungseinheit (6) mit Ansaugöffnungen (23) der Transfereinheit (5) verbunden ist.

10. Vorrichtung (1) nach einem der Ansprüche 6 bis 9, wobei die Abgabeeinheit (7) der Vorrichtung (1) eine Abgabeeinheit (7) zur Abgabe von elektrisch leitfähigem Kleber auf Zeilen (4) von Photovoltaikzellen (3) ist, die auf der Transfereinheit (5) angeordnet sind, und vorzugsweise wobei die Abgabeeinheit (7) zwischen einem Beladepunkt (8) und einem Entladepunkt (9) der Vorrichtung (1) für Zeilen (4) angeordnet ist.

11. Vorrichtung (1) nach Anspruch 10, wobei die Abgabeeinheit (7) eine Anzahl von Abgabedüsen (10) aufweist, die einer Anzahl von Auflageplätzen (11) für Zeilen (4) von Photovoltaikzellen (3) der Transfereinheit (5) entspricht, und/oder wobei die Abgabeeinheit (7), insbesondere Abgabedüsen (10) der Abgabeeinheit (7), in Längsrichtung von auf der Transfereinheit (5) angeordneten Zeilen (4) verfahrbar ist.

12. Vorrichtung (1) nach einem der Ansprüche 6 bis 11, wobei die Vorrichtung (1) ein Magazin (13) zur Bereitstellung von Photovoltaikzellen (3) und/oder eine Übergabeeinheit (14), insbesondere mit einem Handhabungsroboter (15), aufweist, mit der Photovoltaikzellen (3) aus einem oder dem Magazin (13) entnehmbar und/oder auf der Transfereinheit (5) in Zeilen (4) anordenbar sind.

13. Vorrichtung (1) nach einem der vorangehenden Ansprüche, wobei die Vorrichtung (1) zur Kontrolle von Photovoltaikzellen (3) eine Kontrolleinheit (17) aufweist, insbesondere wobei die Kontrolleinheit (17) zumindest ein optisches Kontrollmittel, beispielsweise eine Kamera (18) umfasst.

14. Vorrichtung (1) nach einem der Ansprüche 6 bis 13, wobei die Vorrichtung (1) eine Bestückungseinheit (19), insbesondere mit zumindest einem Greifer (20), vorzugsweise mit zumindest einem Sauggreifer, aufweist, wobei die Bestückungseinheit (19) dazu eingerichtet ist, zumindest eine oder mehrere oder alle Zeilen (4) von Photovoltaikzellen (3), die von der Transfereinheit (5) in einem Entladepunkt (9) bereitstellt werden, aufzunehmen und/oder an einen nachgelagerten Bearbeitungsschritt und/oder Handhabungsschritt, insbesondere an eine nachgelagerte Transporteinheit (21) zu übergeben.

15. Vorrichtung (1) nach einem der Ansprüche 6 bis 14, wobei die Vorrichtung (1) eine der Transfereinheit (5) nachgelagerte Transporteinheit (21) aufweist, mit der zumindest ein mit Zeilen (4) von Photovoltaikzellen (3, 12) bestücktes Solarmodul (2) einer nachgelagerten Bearbeitungsstation zuführbar ist.

16. Vorrichtung (1) nach einem der Ansprüche 6 bis 15, wobei eine Transferbewegung der Transfereinheit (5) quer, insbesondere rechtwinklig, zu einer Längsrichtung von Auflageplätzen (11) für Zeilen (4) auf der Transfereinheit (5) oder in Längsrichtung von Auflageplätzen (11) für Zeilen (4) auf der Transfereinheit (5) ausgerichtet ist.

17. Vorrichtung (1) nach einem der Ansprüche 6 bis 16, wobei eine Transferbewegung der Transfereinheit (5) quer, insbesondere rechtwinklig, zu einer Transportbewegung der Transporteinheit (21) oder in Richtung einer Transportbewegung der Transporteinheit (21) ausgerichtet ist.

## Claims

1. Method for producing solar modules (2), wherein photovoltaic cells (3) are assembled into lines (4) and wherein the solar modules (2) are constructed from electrically interconnected lines (4), wherein at least two lines (4) that are offset in relation to one another are built up and are co-fed to a cell-fitting operation for the solar module (2), wherein offsetting elements (12) are used during the building up of the lines (4) to form an offset of adjacent lines (4) in relation to one another, and wherein, for connecting adjacent lines (4) of photovoltaic cells (3), electrically conductive adhesive is applied with a lateral offset in relation to a longitudinal central axis of a line (4) of photovoltaic cells (3) to the line (4), after which two adjacent lines (4) are adhesively bonded to one another while mutually overlapping.

2. Method according to Claim 1, **characterized in that** the at least two lines (4) are co-fed to the cell-fitting operation for the solar module (2) by means of a motorized transfer unit (5), in particular by means of a tray and/or table and/or by means of a belt conveyor and/or by means of a vacuum table.

3. Method according to one of the preceding claims, **characterized in that** a relative alignment of the photovoltaic cells (3) within one line (4) and/or two different lines (4) is maintained during the feeding.

4. Method according to one of the preceding claims, **characterized in that** a number of co-fed lines (4) is adapted to an application rate of an electrically conductive adhesive and/or **in that** an application rate of an electrically conductive adhesive is adapted to a number of co-fed lines.

5. Method according to one of the preceding claims, **characterized in that** groups of at least two lines (4) are built up in parallel in time and these are fed to a common cell-fitting operation.

6. Device (1) for producing solar modules (2), wherein the device (1) comprises means by which the device (1) is set up for carrying out a method according to one of the preceding claims, specifically a motorized transfer unit (5), with which at least two lines (4) of photovoltaic cells (3) can be co-fed to a cell-fitting operation for a solar module (2) to be produced, and a dispensing unit (7) for dispensing electrically conductive adhesive onto lines (4) of photovoltaic cells (3) and a control unit (22), by which the device (1) is set up for carrying out the method according to one of the preceding claims.

7. Device (1) according to Claim 6, wherein the device has a motorized transfer unit (5), specifically a tray and/or a table and/or a belt conveyor and/or a vacuum table, and preferably wherein the motorized transfer unit (5) is set up to move the photovoltaic cells (3) of the lines (4) from a loading point (8) to an unloading point (9) .

8. Device (1) according to the preceding claim, wherein the transfer unit (5) has at least two support positions (11) for lines (4) of photovoltaic cells (3), preferably wherein the transfer unit has at least one series (24) of suction openings (23) for each support position (11).

9. Device (1) according to Claims 6 to 8, wherein the device (1) has a vacuum generating unit (6), with which lines (4) of photovoltaic cells (3) can be fixed on the transfer unit (5) by a vacuum, in particular wherein the vacuum generating unit (6) is connected to suction openings (23) of the transfer unit (5).

10. Device (1) according to one of Claims 6 to 9, wherein the dispensing unit (7) of the device (1) is a dispensing unit (7) for dispensing electrically conductive adhesive onto lines (4) of photovoltaic cells (3) that are arranged on the transfer unit (5), and preferably wherein the dispensing unit (7) is arranged between a loading point (8) and an unloading point (9) of the device (1) for lines (4).

11. Device (1) according to Claim 10, wherein the dispensing unit (7) has a number of dispensing nozzles (10) which corresponds to a number of support positions (11) for lines (4) of photovoltaic cells (3) of the transfer unit (5), and/or wherein the dispensing unit (7), in particular dispensing nozzles (10) of the dispensing unit (7), is movable in the longitudinal direction of lines (4) arranged on the transfer unit (5).

12. Device (1) according to one of Claims 6 to 11, wherein the device (1) has a magazine (13) for providing photovoltaic cells (3) and/or a transfer unit (14), in particular with a handling robot (15), with which photovoltaic cells (3) can be removed from a or the magazine (13) and/or arranged in lines (4) on the transfer unit (5).

13. Device (1) according to one of the preceding claims, wherein, for monitoring photovoltaic cells (3), the device (1) has a monitoring unit (17), in particular wherein the monitoring unit (17) comprises at least one optical monitoring means, for example a camera (18).

14. Device (1) according to one Claims 6 to 13, wherein the device (1) has a cell-fitting unit (19), in particular with at least one gripper (20), preferably with at least one suction gripper, wherein the cell-fitting unit (19) is set up to receive at least one or more or all of the lines (4) of photovoltaic cells (3) which are provided by the transfer unit (5) at a unloading point (9) and/or to transfer them to a downstream processing step and/or handling step, in particular to a downstream transporting unit (21).

15. Device (1) according to one Claims 6 to 14, wherein the device (1) has a transporting unit (21) downstream of the transfer unit (5), with which at least one solar module (2) fitted with lines (4) of photovoltaic cells (3, 12) can be fed to a downstream processing station.

16. Device (1) according to one of Claims 6 to 15, wherein a transfer movement of the transfer unit (5) is aligned transversely, in particular at right angles, to a longitudinal direction of support positions (11) for lines (4) on the transfer unit (5) or in the longitudinal direction of support positions (11) for lines (4) on the transfer unit (5).

17. Device (1) according to one Claims 6 to 16, wherein a transfer movement of the transfer unit (5) is aligned transversely, in particular at right angles, to a transporting movement of the transporting unit (21) or in the direction of a transporting movement of the transporting unit (21).

## Revendications

1. Procédé pour la fabrication de panneaux solaires (2), selon lequel des cellules photovoltaïques (3) sont assemblées en rangées (4) et selon lequel les panneaux solaires (2) sont constitués de rangées (4) reliées électriquement entre elles, selon lequel au moins deux rangées (4) décalées entre elles sont montées et acheminées ensemble vers un système d'équipement du panneau solaire (2), selon lequel des pièces de décalage (12) sont utilisées lors du montage des rangées (4) pour créer un décalage entre les rangées (4) voisines entre elles et selon lequel, pour relier des rangées (4) voisines de cellules photovoltaïques (3), un adhésif électro-conducteur présentant un décalage latéral par rapport à un axe central longitudinal d'une rangée (4) de cellules photoélectriques (3) est appliqué sur la rangée (4), après quoi deux rangées (4) voisines sont collées l'une avec l'autre en se chevauchant mutuellement.

2. Procédé selon la revendication 1, **caractérisé en ce que** les au moins deux rangées (4) sont acheminées ensemble vers le système d'équipement du panneau solaire (2) au moyen d'une unité de transfert motorisée (5), en particulier au moyen d'une tablette et/ou au moyen d'une table et/ou au moyen d'un convoyeur à bande et/ou au moyen d'une table à dépression.

3. Procédé selon une des revendications précédentes, **caractérisé en ce qu'**une orientation relative des cellules photovoltaïques (3) au sein d'une rangée (4) et/ou de deux rangées (4) différentes est maintenue pendant l'acheminement.

4. Procédé selon une des revendications précédentes, **caractérisé en ce qu'**un nombre de rangées (4) acheminées ensemble est adapté à une vitesse d'application d'un adhésif électro-conducteur et/ou qu'une vitesse d'application d'un adhésif électro-conducteur est adaptée à un nombre de rangées acheminées ensemble.

5. Procédé selon une des revendications précédentes, **caractérisé en ce que** sont constitués parallèlement dans le temps des groupes d'au moins deux rangées (4) qui sont acheminées vers un système d'équipement commun.

6. Dispositif (1) pour la fabrication de panneaux solaires (2), lequel dispositif (1) comporte des moyens par le biais desquels ce dispositif (1) est équipé pour la mise en oeuvre d'un procédé selon une des revendications précédentes, à savoir une unité de transfert motorisée (5) avec laquelle au moins deux rangées (4) de cellules photovoltaïques (3) peuvent être acheminées ensemble vers un système d'équipement d'un panneau solaire (2) à fabriquer et une unité de distribution (7) pour la distribution d'adhésif électro-conducteur sur des rangées (4) de cellules photovoltaïques (3) et une unité de commande (22) par le biais de laquelle le dispositif (1) est équipé pour la mise en oeuvre d'un procédé selon une des revendications précédentes.

7. Dispositif (1) selon la revendication 6, lequel dispositif comporte l'unité de transfert motorisée (5), à savoir une tablette et/ou une table et/ou un convoyeur à bande et/ou une table à dépression, et de préférence dans lequel l'unité de transfert motorisée (5) est équipée pour déplacer les cellules photovoltaïques (3) des rangées (4) d'un point de chargement (8) à un point de déchargement (9).

8. Dispositif (1) selon une des revendications précédentes, dans lequel l'unité de transfert (5) comporte au moins deux emplacements de support (11) pour des rangées (4) de cellules photovoltaïques (3), l'unité de transfert (5) comportant de préférence au moins une série (24) d'orifices d'aspiration (23) pour chaque emplacement de support (11).

9. Dispositif (1) selon une des revendications 6 à 8, lequel dispositif (1) comporte une unité de génération de dépression (6) avec laquelle des rangées (4) de cellules photovoltaïques (3) peuvent être fixées par dépression sur l'unité de transfert (5), en particulier l'unité de génération de dépression (6) étant reliée avec des orifices d'aspiration (23) de l'unité de transfert (5).

10. Dispositif (1) selon une des revendications 6 à 9, l'unité de distribution (7) du dispositif (1) étant une unité de distribution (7) pour la distribution d'adhésif électro-conducteur sur des rangées (4) de cellules photovoltaïques (3) qui sont disposées sur l'unité de transfert (5), et l'unité de distribution (7) étant de préférence disposée entre un point de chargement (8) et un point de déchargement (9) du dispositif (1) pour les rangées (4).

11. Dispositif (1) selon la revendication 10, dans lequel l'unité de distribution (7) comporte un nombre de buses de distribution (10) qui correspond à un nombre d'emplacements de support (11) pour les rangées (4) de cellules photovoltaïques (3) de l'unité de transfert (5), et/ou dans lequel l'unité de distribution (7), en particulier les buses de distribution (10) de l'unité de distribution (7), peut être déplacée dans la direction longitudinale des rangées (4) disposées sur l'unité de transfert (5).

12. Dispositif (1) selon une des revendications 6 à 11, lequel dispositif (1) comporte un magasin (13) pour la préparation de cellules photovoltaïques (3) et/ou une unité de transmission (14), en particulier avec un robot de manipulation (15), avec laquelle des cellules photovoltaïques (3) peuvent être extraites d'un ou du magasin (13) et/ou disposées en rangées (4) sur l'unité de transfert (5).

13. Dispositif (1) selon une des revendications 6 à 11, lequel dispositif (1) comporte une unité de contrôle (17) pour le contrôle des cellules photovoltaïques (3), en particulier l'unité de contrôle (17) comprenant au moins un moyen de contrôle optique, par exemple une caméra (18).

14. Dispositif (1) selon une des revendications 6 à 13, lequel dispositif (1) comporte une unité d'équipement (19), en particulier avec au moins un organe de préhension (20), de préférence avec au moins un organe de préhension à aspiration, laquelle unité d'équipement (19) est équipée pour prendre au moins une ou plusieurs ou toutes les rangées (4) de cellules photovoltaïques (3) qui sont préparées par l'unité de transfert (5) dans un point de déchargement (9) et/ou pour les transmettre à une étape de traitement et/ou une étape de manipulation en aval, en particulier à une unité de transport (21) en aval.

15. Dispositif (1) selon une des revendications 6 à 14, lequel dispositif (1) comporte une unité de transport (21) en aval de l'unité de transfert (5), avec laquelle au moins un panneau solaire (2) équipé de rangées (4) de cellules photovoltaïques (3, 12) peut être envoyé à une station de traitement en aval.

16. Dispositif (1) selon une des revendications 6 à 15, dans lequel un mouvement de transfert de l'unité de transfert (5) est orienté transversalement, en particulier perpendiculairement, à une direction longitudinale des emplacements de support (11) pour les rangées (4) sur l'unité de transfert (5) ou dans la direction longitudinale des emplacements de support (11) pour les rangées (4) sur l'unité de transfert (5).

17. Dispositif (1) selon une des revendications 6 à 16, dans lequel un mouvement de transfert de l'unité de transfert (5) est orienté transversalement, en particulier perpendiculairement, à un mouvement de transport de l'unité de transport (21) ou dans la direction de transport de l'unité de transport (21).
